## Europäisches Patentamt
## European Patent Office
## Office européen des brevets

(19)

(11) Publication number: **0 123 439**
**B1**

(12)

# EUROPEAN PATENT SPECIFICATION

(45) Date of publication of patent specification: **24.08.88**

(51) Int. Cl.⁴: **H 02 K 11/00**

(21) Application number: **84301993.6**

(22) Date of filing: **23.03.84**

(54) **Method for determining a surge reversevoltage across a rectifying element.**

(30) Priority: **25.03.83 JP 50892/83**

(43) Date of publication of application:
**31.10.84 Bulletin 84/44**

(45) Publication of the grant of the patent:
**24.08.88 Bulletin 88/34**

(84) Designated Contracting States:
**CH DE FR GB IT LI**

(56) References cited:

PROCEEDINGS OF THE IEE, vol. 121, no. 9,
September 1974, London, GB; B. MELLITT et al.
"Voltage-time integral method for measuring
machine inductance", pages 1016-1017
ETZ-A, vol. 98, no. 10, 1977 R. GERLACH
"Erregung und Spannungsregelung bei
Synchrongeneratoren", pages 664-666

(73) Proprietor: **MITSUBISHI DENKI KABUSHIKI
KAISHA**
**2-3, Marunouchi 2-chome Chiyoda-ku
Tokyo 100 (JP)**

(72) Inventor: **Uda, Susumu**
**6-8-301, Takamaru 7-chome Tarumi-ku
City of Kobe Hyogo Prefecture (JP)**
Inventor: **Maeda, Susumu**
**1-22, Hayashi 2-chome
City of Akashi Hyogo Prefecture (JP)**
Inventor: **Suzuki, Kazuichi**
**275E501, Kozubashi Tamatsu-cho Nishi-ku
City of Kobe Hyogo Prefecture (JP)**
Inventor: **Amagasa, Nobutada**
**2-1-17, Shinwa-dai Tarumi-ku
City of Kobe Hyogo Prefecture (JP)**

(74) Representative: **Lawson, David Glynne et al
MARKS & CLERK 57-60 Lincoln's Inn Fields
London WC2A 3LS (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a method for determining an inductor surge overvoltage, and in particular to a method for determining the withstanding voltage of a rectifying circuit in a circuit using an inductor.

Conventionally, in a rectifying circuit connected between a three phase power supply source for example and a DC load, respective arms of semiconductor rectifier elements such as diodes or thyristors have heretofore been provided with a so-called snubber circuit connected in parallel with the semiconductor rectifier element. Each of the snubber circuits is a protective circuit which consists of a series combination of a resistor and a capacitor and serves to suppress a surge overvoltage such as a counter electromotive force (e = —Ldi/dt) resulting from the inductance of an indicator included in the power source and/or the load when the circuit current is commutated.

Since the surge overvoltage has various values due to the value of voltage or current flowing through the rectifying circuit, the circuit condition, the leakage inductance existent in the power source or the load, the element characteristics etc., it has been considered in view of these factors as to whether or not the snubber circuits are required and what kind of semiconductor element should be selected. In the condition of a substantially low circuit voltage, a rectifier element for a high withstanding voltage has been used to realize a relatively simple circuit design without the snubber circuits.

However, generally, rectifying circuits are utilized with high voltage circuits, and therefore require snubber circuits the surge voltages of which have been predetermined, for example, with respect to the withstanding voltage ratings of semiconductor devices associated with the snubber circuits the time constants (CR) of which are determined from a commutation surge absorption characteristic curve. In order to select the value of the surge voltage, a calculating method has been adopted as one example using the ratio between the energy stored in the inductance of an inductor included in the power source or the load and the energy that can be charged in the capacitor in the snubber circuit.

Therefore, such a conventional calculating method for a surge overvoltage has been problematically unreliable and uneconomical because in the case of a high current and high voltage-exciter apparatus utilized with a turbine generator having a large capacity for example or in the case of a power source or a load having a large leakage inductance, the requirements of a snubber circuit is excessive and the number of the parts used is undesirably increased.

It is accordingly an object of the invention to provide a method for determining a surge reverse voltage across a rectifying element, that is, the reverse voltage due to the inductance of a coil, without the defects of the prior art set forth in the above. This method broadly comprises the determination and, accordingly, the selection of the optimum withstand capacity of a semiconductor rectifying device for overvoltage in the light of the frequency characteristics of an equivalent inductance including the distributed capacitance (stray capacitance) as the leakage inductance of a power source or a load.

Specifically, the present invention comprises a method for determining a surge reverse voltage across a rectifying element in a circuit which comprises an A.C. power source a coil having an equivalent resistance (Req) and equivalent inductance (Leq), and a rectifying circuit including said rectifying element having an equivalent resistance (R) and equivalent capacitance (C) and connected between said A.C. power source and said coil for supplying a D.C. voltage to said coil, characterised in that it comprises:—

a first step of measuring the frequency characteristic of the equivalent inductance (Leq) of said coil by applying a variable frequency signal across said coil;

a second step of calculating a forward current (If) flowing through said coil and said rectifying element to calculate the time point t1 when said forward current crosses zero;

a third step of calculating an equivalent inductance (Lr) corresponding to an arbitrarily selected provisional frequency (Fr) from said frequency characteristic to determine whether or not said calculated equivalent inductance (Lr) meets the resonance condition (CR' <4Lr) of an equivalent circuit formed of the equivalent resistance (Req) and said calculated equivalent inductance (Lr) of said inductance as well as the equivalent resistance (R) and the equivalent capacitance (C) of said rectifying element, where R' = Req + R;

a fourth step of, if said resonance condition is met, calculating a resonance frequency (Fr') of said equivalent circuit and, if necessary, repeating the calculation with different values for the selected provisional resonance frequency, so as to determine an optimum resonance frequency (Fr') closest to said selected provisional resonance frequency (Fr); and

a fifth step of calculating the reverse voltage across said rectifying element in said circuit at said time point t1 from the equivalent resistance (Req) and the equivalent inductance (Lr), corresponding to said optimum resonance frequency in said frequency characteristic, of said inductor and from the equivalent resistance (R) and capacitance (C) of said rectifying element.

The present invention also provides a method of manufacturing electrical apparatus comprising an inductor and a semi-conductor rectifying circuit connected to the inductor, characterised in that the reverse voltage (Vdi) is determined for a rectifying element of said rectifying circuit by the method just described, and the semi-conductor rectifying circuit is made to have a withstand voltage corresponding to the reverse voltage determined in this way.

The present invention will be more readily apparent from the preferred embodiment as illustrated in the accompanying drawings in which:

Figure 1 shows a circuit diagram of a brushless generator not requiring a superfluous snubber circuit according to the method of the present invention;

Figure 2 shows an equivalent circuit diagram of a rectifying circuit including a field coil or inductor;

Figure 3 shows waveform diagrams of voltage and current observed in the circuit of Figure 2;

Figure 4 shows a perspective view of a field coil;

Figure 5 shows an equivalent circuit diagram of the distributed capacitance and inductance, for a high frequency, of the coil of Figure 4;

Figure 6 shows a frequency characteristic curve of an equivalent field circuit inductance;

Figure 7 shows a flow chart illustrating one embodiment of the invention; and,

Figure 8 shows a more detailed equivalent circuit diagram of a rectifying circuit in Fig. 2.

Throughout the Figures, the same symbols indicate identical or corresponding portions.

## DETAILED DESCRIPTION OF THE INVENTION

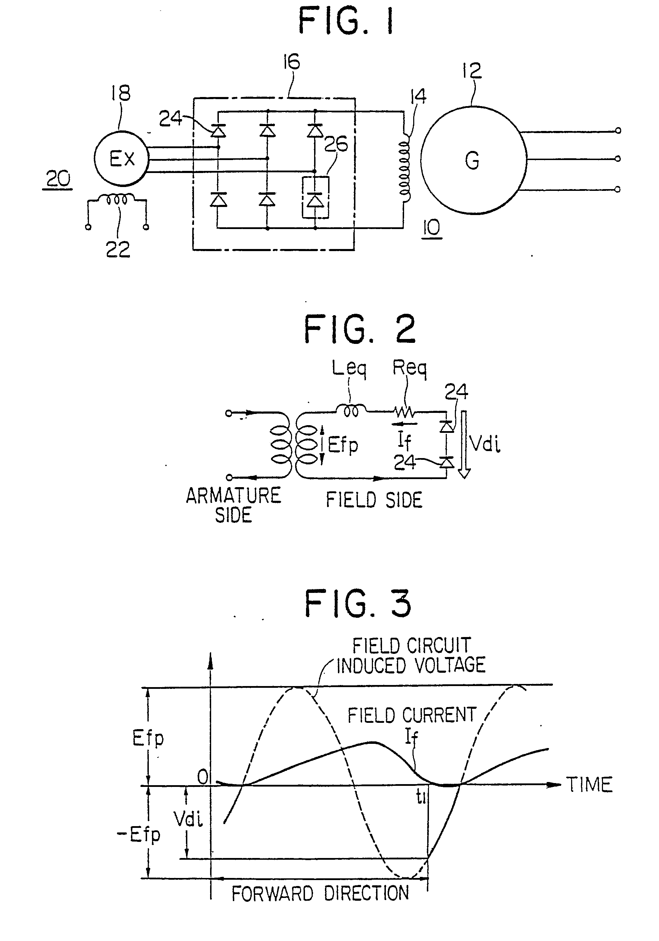

Referring now to the drawings, and in particular to Fig. 1, one preferred embodiment for performing the method of the invention will be described with reference to a brushless generator circuit including a coil or inductor. A brushless generator generally designated by reference numeral 10 has an armature 12 and a field coil 14. The field coil 14 is connected across the DC terminals of a rectifying circuit 16 enclosed by dot-dash lines and serves as a load for the rectifying circuit 16. The three phase AC terminals of the rectifying circuit 16 are connected to the armature 18 of an AC brushless exciter, for the generator 10, generally designated by reference numeral 20 which also includes a field coil 22. The rectifying circuit 16 includes semiconductor rectifying devices 24 such as diodes, each of which is included in an arm circuit 26 as schematically enclosed by dot-dash lines.

The brushless generator circuit as shown in Fig. 1 rectifies an AC voltage generated of the armature 18 of the AC exciter 20 through the rectifying circuit 16 without any snubber circuit as required by the prior art rectifier, and supplies the rectified DC voltage to the field coil 14 to cause the armature 12 of the generator 10 to generate a desired three phase voltage.

Thus, the circuit arrangement of the rectifying circuit 16 which is a three phase full wave rectifier is provided without any special overvoltage protective circuit such as a snubber circuit for the semiconductor rectifying device 24 as indicated above. The reason for this will be described herebelow.

In general, as set forth in the above, an arm snubber circuit including a capacitor has been provided for a brushless exciter apparatus for a large capacity turbine generator of more than 350MVA in order to suppress a commutation surge introduced into the semiconductor rectifying device and to allot a reverse voltage induced in the generator field coil at the time of asynchronous operation, for example, to the positive and negative arms. Particularly, such a reverse voltage will define more exactly the withstanding voltage capability of the rectifying circuit as the capacity of a generator is increased. The field equivalent circuit at the time of the asynchronous operation is shown in Fig. 2 and the circuit phenomenon of Fig. 2 is shown in Fig. 3.

In Fig. 2, the closed loop at the field side includes an inductance Leq which equivalently indicates the leakage inductance of the generator field coil 14 and a resistance Req which equivalently indictates the resistance value of the field coil 14.

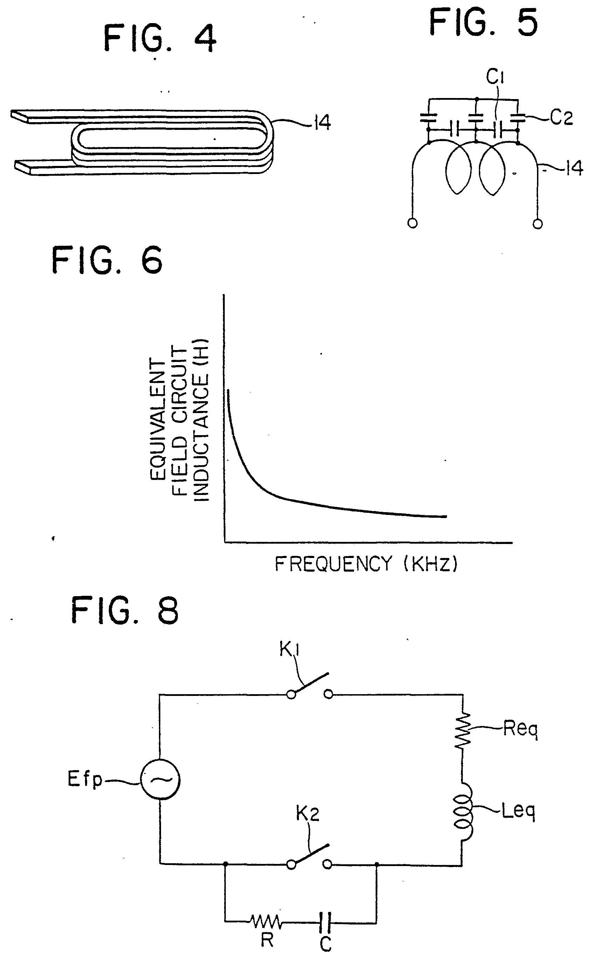

When the field coil 14 has voltage induced thereacross in the asynchronous operation, a field current $I_f$ flows as shown by a solid line in Fig. 3 while the field current $I_f$ is blocked by the semiconductor rectifying devices 24 to apply the induced voltage Efp (dotted line) as a reverse voltage Vdi (Figs. 2 and 3) across the rectifying circuit 16. During the occurrence of the reverse voltage Vdi, it is found that the commutation surge of the semiconductor rectifying device occurs and a resonance phenomenon between the leakage inductance Leq and the capacitance of the semiconductor rectifying device or an associated circuit if any occurs. Since the surge frequency and the resonance frequency are considerably high, it is necessary in a coil configuration shown in Fig. 4 to consider distributed capacitances C1 and C2 between the coil turns in a distributed constant circuit shown in Fig. 5.

In order that the distributed capacitance be easily taken into consideration, the impedance of the field coil 14 is substituted by an equivalent leakage inductance for the distributed capacitance to be easily illustrated while one example of the frequency characteristic of the equivalent leakage inductance is shown in Fig. 6. As seen from the characteristic curve in Fig. 6, the equivalent leakage inductance decreases as the frequency increases. Therefore, the energy stored in the equivalent leakage inductance is reduced in the case of a high frequency as in the above and so the withstanding voltage capability of the rectifying circuit can be very small, so that the snubber circuit or a voltage dividing capacitor is not required. Namely, on the basis of the frequency characteristic curve the determination of the surge/resonance frequency provides a certain equivalent leakage inductance and if the frequency is considerably high then superfluous protective circuits such as snubber circuits can be made unnecessary.

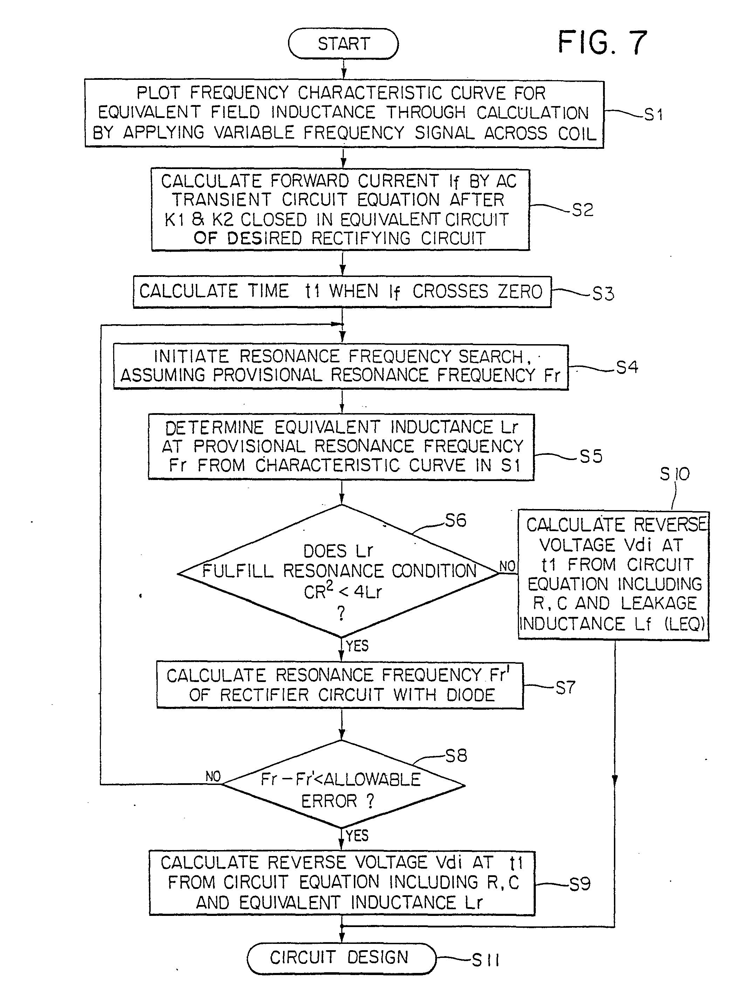

The flow chart of Fig. 7 shows one embodiment of the method for determining an inductor surge overvoltage according to the present invention, the following steps being performed:

Step 1

(S1); by taking out solely a coil, such as the field coil 14 shown in Figs. 1 and 4, connected to a rectifying circuit in a desired circuit such as the brushless generator circuit shown in Fig. 1 and applying frequency signals across the coil, the equivalent field inductance of the coil is determined in a well-known calculating method. Namely, a variable frequency signal generator is connected across the coil to measure the voltage value across the coil, the current value through the coil, and the phase relation between the voltage and the current at the respective frequency. From these data, a real number portion and an imaginary number portion of the impedance at each frequency is determined wherein the imaginary number portion of the impedance corresponds to the equivalent field inductance. Thus, by varying the frequency of the signal generator, a frequency characteristic curve for equivalent field inductances as shown in Fig. 6 is plotted.

Step 2 (includes parts S2 and 3):

(S2); the differential equation of the AC transient circuit of a forward current $i_f$ after having formed the desired rectifying circuit is calculated. The desired rectifying circuit can be equivalently drawn as shown in Fig. 8 wherein Efp designates an induced voltage with a low frequency in the field circuit at the time of asynchronous operation, Req the equivalent resistance of the field circuit, Leq the equivalent inductance of the field circuit, K1 a main switch, K2 an auxiliary switch, R the resistance of a semiconductor device such as a diode represented by the switch K2, and C the capacitance of the semiconductor device. It will be seen that the equivalent circuit of Fig. 8 is a more detailed one of Fig. 2 as to the portion of the semiconductor rectifying device, e.g. the diode. The above equivalent circuit is formed by closing the switches K1 and K2 as an initial step. The differential equation of the AC transient circuit of the equivalent of Fig. 8 is well known to any one of ordinary skills in the art and is therefore omitted herein.

(S3); a time t1 when the forward current $i_f$ crosses zero is calculated from the above AC transient circuit equation. The relationship between the current and the voltage is graphically shown in Fig. 3 as set forth previously.

Step 3 (includes parts S4 to S6):

(S4); an arbitrary frequency is used as a provisional resonance frequency Fr to find out a proper resonance frequency. The arbitrary frequency is initiated to select the above noted asynchronous low frequency.

(S5); an equivalent inductance Lr at the provisional resonance frequency Fr is determined from the frequency characteristic curve obtained by the step 1.

(S6); on the basis of the resonance condition $CR^2 < 4Lr$ in the differential equation of the AC transient circuit shown in Fig. 8 in which the switch K2 is now assumed to be opened, the presence or absence of the resonance is checked. The reason why the resonance is checked is because the reverse voltage across the diode at the resonance time is much higher than that at the non-resonance time and therefore the circuit design should be decided thereon.

Step 4 (includes parts S7 and 8):

(S7); if the resonance is found to be present, then a resonance frequency Fr' is calculated from the equivalent circuit shown in Fig. 8 because there are some frequencies which are to be found as meeting the resonance condition in the step 6. As is well known, the resonance frequency Fr' is determined from the imaginary portion of the impedance of the equivalent circuit in Fig. 8.

(S8); check is made whether Fr minus Fr' is smaller than a predetermined allowable error to find out the optimum resonance frequency among the frequencies Fr. If Fr—Fr'> the allowable error, then the flow path is returned to the step 4 to take a different provisional resonance frequency, resulting in repeated steps of S4—S8 until there is found a suitable resonance frequency Fr' which meets the condition Fr—Fr'< the allowable error.

Step 5 (includes part S9):

(S9); if Fr—Fr' < the allowable error, then a reverse voltage Vdi at the time t1 (Fig. 3) is calculated from the differential equation with the switch K2 being open by using the equivalent inductance Lr corresponding to the provisional resonance frequency which has now been found to be a proper or optimum resonance frequency. It should be noted that in Fig. 8, the voltage across the R—C combination when the switch K2 is opened at the time t1 corresponds to the diode reverse voltage. In this step 9, the resonance frequency is so high that a snubber circuit is not required as seen from the characteristic curve shown in Fig. 6.

Step 10

(S10); if the resonance is found to be absent in the step S6, a reverse voltage Vdi at the time t1 (Fig. 3) is calculated by using the leakage reactance Lf which is substantially the same as the equivalent inductance Leq at the asynchronous low frequency. It should be noted that in Fig. 8 the voltage across the R—C combination when the switch K2 is opened at the time t1 corresponds to the diode reverse voltage. The reverse voltage Vdi calculated by this step 10 is so low that a snubber circuit is not required. The calculation of the time t1 in the step S3 may be instead made in this step or the step 9.

Step 11

(S11); after the reverse voltage has been determined in the steps 9 or 10, a circuit design is made in view of the determined reverse voltage required as the withstanding voltage capability of the rectifying circuit connected to the coil.

It is to be noted that the above described embodiment takes for example the inductance of the generator field coil of a brushless generator. However, the invention may also be applied to the leakage inductance of an AC exciter armature coil and the leakage inductance of a transformer coil. Furthermore, it is apparent that the above description refers to one example for elimination of a snubber circuit. However, the invention may also be applied to the reduction of the withstanding voltage capability and thyristors may also be substituted for the diodes used as a semiconductor device.

As in the foregoings, according to the invention, it is advantageous that in designing a rectifying circuit, superfluous snubber circuits may not be used and devices having a high withstanding voltage capability can be eliminated by considering an equivalent inductance including a distributed capacity in addition to the coil inductance of a load or a power source, resulting in enhanced reliability and a cheap rectifying apparatus.

## Claims

1. A method for determining a surge reverse voltage across a rectifying element (24) in a circuit which comprises an A.C. power source (20), a coil (14) having an equivalent resistance (Req) and equivalent inductance (Leq), and a rectifying circuit (16) including said rectifying element having an equivalent resistance (R) and equivalent capacitance (C) and connected between said A.C. power source and said coil for supplying a D.C. voltage to said coil, characterised in that it comprises:—

a first step (S1) of measuring the frequency characteristic of the equivalent inductance (Leq) of said coil (14) by applying a variable frequency signal across said coil;

a second step (S2—3) of calculating a forward current (If) flowing through said coil (14) and said rectifying element (24) to calculate the time point t1 when said forward current crosses zero;

a third step (S4—6) of calculating an equivalent inductance (Lr) corresponding to an arbitrarily selected provisional frequency (Fr) from said frequency characteristic to determine whether or not said calculated equivalent inductance (Lr) meets the resonance condition (CR' <4Lr) of an equivalent circuit formed of the equivalent resistance (Req) and said calculated equivalent inductance (Lr) of said inductance as well as the equivalent resistance (R) and the equivalent capacitance (C) of said rectifying element, where R' = Req + R;

a fourth step (S7—8) of, if said resonance condition is met, calculating a resonance frequency (Fr') of said equivalent circuit and, if necessary, repeating the calculation with different values for the selected provisional resonance frequency, so as to determine an optimum resonance frequency (Fr') closest to said selected provisional resonance frequency (Fr); and

a fifth step (S9) of calculating the reverse voltage across said rectifying element in said circuit at said time point t1 from the equivalent resistance (Req) and the equivalent inductance (Lr), correspoonding to said optimum resonance frequency in said frequency characteristic, of said inductor and from the equivalent resistance (R) and capacitance (C) of said rectifying element.

2. A method according to claim 1, wherein the fourth step comprises a step of calculating whether the difference between said provisional resonance frequency (Fr) and the calculated resonance frequency (Fr') is smaller than a predetermined allowable error, a step of returning to the third step when the calculated difference is not smaller than the allowable error, and a step of repeating the steps of the method until the calculated difference is smaller than the predetermined allowable error.

3. A method of manufacturing electrical apparatus comprising an inductor (14) and a semi-conductor rectifying circuit (16) connected to the inductor, characterised in that the reverse voltage (Vdi) is determined for a rectifying element (24) of said rectifying circuit by the method claimed in claim 1 or 2, and the semi-conductor rectifying circuit is made to have a withstand voltage corresponding to the reverse voltage determined in this way.

## Patentansprüche

1. Verfahren zur Bestimmung einer Sperrüberspannung an einem Gleichrichterelement (24) in einer Schaltung, die eine Wechselstromquelle (20), eine Spule (14) mit einem Ersatzwiderstand (Req) und einer Ersatzinduktivität (Leq) sowie eine Gleichrichterschaltung (16) aufweist, die das Gleichrichterelement enthält, das einen Ersatzwiderstand (R) und eine Ersatzkapazität (C) aufweist und das zwischen die Wechselstromquelle und die Spule geschaltet ist, um der Spule eine Gleichspannung zu liefern, dadurch gekennzeichnet, daß es folgendes umfaßt:

einen ersten Schritt (S1) zur Messung des Frequenzganges der Ersatzinduktivität (Leq) der Spule (14) durch Anlegen eines variablen Frequenzsignals parallel zu Spule;

einen zweiten Schritt (S2, S3) zur Berechnung eines Durchlaßstromes (If), der durch die Spule (14) und das Gleichrichterelement (24) fließt, um den Zeitpunkt t1 zu berechnen, wenn der Durchlaßstrom einen Nulldurchgang hat;

einen dritten Schritt (S4—S6) zur Berechnung einer Ersatzinduktivität (Lr), die einer willkürlich gewählten vorläufigen Frequenz (Fr) aus dem Frequenzgang entspricht, um festzustellen, ob die berechnete Ersatzinduktivität (Lr) die Resonanzbedingung (Cr' < Lr) einer Ersatzschaltung erfüllt, die aus dem Ersatzwiderstand (Req) und der berechneten Ersatzinduktivität (Lr) der Induktivität sowie dem Ersatzwiderstand (R) und der Ersatzkapazität (C) des Gleichrichterelementes gebildet ist, wobei R' = Req + R gilt;

einen vierten Schritt (S7, S8), um wenn die Resonanzbedingung erfüllt ist, eine Resonanzfrequenz (Fr') der Ersatzschaltung zu berechnen und gegebenenfalls die Berechnung mit anderen Werten für die gewählte vorläufige Resonanzfrequenz zu wiederholen, um eine optimale Resonanzfrequenz (Fr) zu bestimmen, die der gewählten vorläufigen Resonanzfrequenz (Fr) am nächsten ist; und

einen fünften Schritt (S9) zur Berechnung der Sperrspannung über dem Gleichrichterelement in der Schaltung zu dem Zeitpunkt t1 aus dem Ersatzwiderstand (Req) un der Ersatzinduktivität (Lr), entsprechend der optimalen Resonanzfrequenz in dem Frequenzgang, der induktivität und aus dem Ersatzwiderstand (R) und der Kapazität (C) des Gleichrichterelementes.

2. Verfahren nach Anspruch 1, wobei der vierte Schritt einen Schritt zur Berechnung, ob die Differenz zwischen der vorläufigen Resonanzfrequenz (Fr) und der berechneten Resonanzfrequenz (Fr') kleiner ist als ein vorgegebenen zulässiger Fehler, einen Schritt zur Rückkehr zum dritten Schritt, wenn die berechnete Differenz nicht kleiner ist als der zulässige Fehler, und einen Schritt der Wiederholung der Schritte des Verfahrens umfaßt, bis die berechnete Differenz kleiner ist als der vorgegebene zulässige Fehler.

· 3. Verfahren zur Herstellung einer elektrischen Vorrichtung, die eine Induktivität (14) und eine an die Induktivität angeschlossene Halbleiter-Gleichrichterschaltung (16) aufweist, dadurch gekennzeichnet, daß die Sperrspannung (Vdi) für ein Gleichrichterelement (24) der Gleichrichterschaltung mit dem Verfahren nach Anspruch 1 oder 2 bestimmt wird und die Halbleiter-Gleichrichterschaltung so ausgelegt wird, daß sie eine Stehspannung hat, die der auf diese Weise bestimmten Sperrspannung entspricht.

**Revendications**

1. Méthode pour la détermination d'une surtension inverse dans un élément redresseur (24) dans un circuit qui comprend une source de courant alternatif (20), une bobine (14) ayant une résistance équivalente (Req) et une inductance équivalente (Leq), et un circuit redresseur (16) comprenant ledit élément redresseur ayant une résistance équivalente (R) et une capacité équivalente (C) et connecté entre ladite source de courant alternatif et ladite bobine pour fournir une tension continue à ladite bobine, caractérisé en ce qu'elle comprend:

une première étape (S1) de mesure de la caractéristique de fréquences de l'inductance équivalente (Leq) de ladite bobine (14) par application d'un signal à fréquence variable à ladite bobine;

une seconde étape (S2—3) de calcul d'un courant direct (If) s'écoulant à traverse ladite bobine (14) et ledit élément redresseur (24) pour calculer le point dans le temps t1 où ledit courant direct passe par zéro;

une troisième étape (S4—6) de calcul d'une inductance équivalente (Lr) correspondant à une fréquence provisoire (Fr) choisie arbitrairement sur ladite caractéristique de fréquences pour déterminer si oui ou non ladite inductance équivalente calculée (Lr) répond à la condition de résonance (CR' <4Lr) d'un circuit équivalent formé de la résistance équivalente (Req) et de ladite inductance équivalente calculée (Lr) de ladite inductance ainsi que la résistance équivalente (R) et la capacité équivalente (C) dudit élément redresseur, où R' = Req + R;

une quatrième étape (S7—8) de, si ladite condition de résonance est remplie, calcul d'une fréquence de résonance (Fr') dudit circuit équivalent et, si nécessaire, répétition du calcul avec des valeurs différentes pour la fréquence de résonance provisoire choisie, afin de déterminer une fréquence optimale de résonance (Fr') la plus proche de ladite fréquence provisoire choisie de résonance (Fr); et

une cinquième étape (S9) de calcul de la tension inverse dans ledit élément redresseur dans ledit circuit audit point t1 dans le temps à partir de la résistance équivalente (Req) et de l'inductance équivalente (Lr), correspondant à ladite fréquence optimale de résonance dans ladite caractéristique de fréquences, dudit inducteur et de la résistance équivalente (R) et de la capacité (C) dudit élément redresseur.

2. Méthode selon la revendication 1, où la quatrième étape comprend une étape de calculer si la différence entre ladite fréquence provisoire de résonance (Fr) et la fréquence de résonance calculée (Fr') est plus faible qu'une erreur permissible prédéterminée, une étape de retour à la troisième étape lorsque la différence calculée n'est pas plus faible que l'erreur permissible et une étape de répéter les étapes de la méthode jusqu'à ce que la différence calculée soit plus faible que l'erreur permissible prédéterminée.

3. Méthode de fabrication d'un appareil électrique comprenant un inducteur (14) et un circuit redresseur à semiconducteurs (16) connecté à l'inducteur, caractérisée en ce que la tension inverse (Vdi) est déterminée pour un élément redresseur (24) dudit circuit redresseur par la méthode selon la revendication 1 ou 2 et le circuit redresseur à semiconducteurs est forcé à avoir une tension résistante correspondant à la tension inverse déterminée de cette manière.

# FIG. 1

# FIG. 2

# FIG. 3

1

# FIG. 4

# FIG. 5

# FIG. 6

EQUIVALENT FIELD CIRCUIT INDUCTANCE (H)

FREQUENCY (KHZ)

# FIG. 8

FIG. 7

( START )

↓

PLOT FREQUENCY CHARACTERISTIC CURVE FOR EQUIVALENT FIELD INDUCTANCE THROUGH CALCULATION BY APPLYING VARIABLE FREQUENCY SIGNAL ACROSS COIL — S1

↓

CALCULATE FORWARD CURRENT If BY AC TRANSIENT CIRCUIT EQUATION AFTER K1 & K2 CLOSED IN EQUIVALENT CIRCUIT OF DESIRED RECTIFYING CIRCUIT — S2

↓

CALCULATE TIME $t1$ WHEN If CROSSES ZERO — S3

↓

INITIATE RESONANCE FREQUENCY SEARCH, ASSUMING PROVISIONAL RESONANCE FREQUENCY Fr — S4

↓

DETERMINE EQUIVALENT INDUCTANCE Lr AT PROVISIONAL RESONANCE FREQUENCY Fr FROM CHARACTERISTIC CURVE IN S1 — S5

↓

DOES Lr FULFILL RESONANCE CONDITION $CR^2 < 4Lr$ ? — S6

— NO → CALCULATE REVERSE VOLTAGE Vdi AT $t1$ FROM CIRCUIT EQUATION INCLUDING R, C AND LEAKAGE INDUCTANCE Lf (LEQ) — S10

↓ YES

CALCULATE RESONANCE FREQUENCY $Fr'$ OF RECTIFIER CIRCUIT WITH DIODE — S7

↓

$Fr - Fr' < $ ALLOWABLE ERROR ? — S8

NO →

↓ YES

CALCULATE REVERSE VOLTAGE Vdi AT $t1$ FROM CIRCUIT EQUATION INCLUDING R, C AND EQUIVALENT INDUCTANCE Lr — S9

↓

( CIRCUIT DESIGN ) — S11